# EUROPEAN PATENT APPLICATION

(11) **EP 4 683 229 A1**
(43) Date of publication of application: **21.01.2026**
(21) Application number: 25190133.6
(22) Date of filing: 17.07.2025
(51) Int. Cl.: H03L 1/00, H03L 7/08, H03L 7/091, H03L 7/099

(54) **SAMPLING PHASE INTERPOLATOR**

(30) Priority: 18.07.2024 US 202463672783 P; 16.07.2025 US 202519270523
(71) Applicant: MEDIATEK INC., Hsinchu City 30078 (TW)
(72) Inventor: HUNG, Shih-Che, 30078 Hsinchu City (TW); KAO, Chien-Kai, 30078 Hsinchu City (TW)
(74) Representative: Hoefer & Partner Patentanwälte mbB

(57) **Abstract**

The present invention provides phase interpolator (200) including a phase detector (210), a filter (220) and an oscillator (230) is disclosed. The phase detector (210) is configured to receive a first clock signal and a second clock signal, and sample the first clock signal and the second clock signal to generate a detection result, wherein phases of the first clock signal and the second clock signal are different. The filter (220) is configured to filter the detection result to generate a filtered detection result. The oscillator (230) is configured to control frequencies of the first clock signal and the second clock signal, or control a frequency of a sampling clock signal of the phase interpolator according to the filtered detection result.

## Description

### Field of the Invention

The present invention relates to a phase interpolator.

### Background of the Invention

In high-speed data transmission, the receiver needs a clock signal synchronized with the transmitted data to correctly interpret it. However, during transmission, the clock signal can be affected by attenuation, noise, and jitter, leading to a loss of synchronization between the clock and data. The function of a Clock and Data Recovery (CDR) circuit is to extract timing information from the received data stream, generate a clock synchronized with the data, and simultaneously recover the original data.

Phase Interpolator (PI)-based CDRs are widely used due to their advantages such as high integration, low power consumption, and fast lock times. A typical PI-based CDR generally includes a clock generator, multiple phase interpolators, a phase detector, and other control circuits. However, the non-linearity between the phase interpolator's control codes and the corresponding phase of clock signal may affect the eye width of the generated data. Furthermore, circuit components within a PI-based CDR may experience integral nonlinearity mismatch due to semiconductor manufacturing variations. Specifically, variations in the semiconductor process across multiple phase interpolators, and/or variations in the semiconductor process across multiple components within the phase interpolator may significantly impact the quality of the generated data.

### Summary of the Invention

Therefore, one of the objectives of the present invention is to propose a phase interpolator that can generate accurate phases, thereby resolving the issues described in the prior art.

This is achieved by a phase interpolator according to claim 1. The dependent claims pertain to corresponding further developments and improvements.

As will be seen more clearly from the detailed description following below, a phase interpolator comprising a phase detector, a filter and an oscillator is disclosed. The phase detector is configured to receive a first clock signal and a second clock signal, and sample the first clock signal and the second clock signal to generate a detection result, wherein phases of the first clock signal and the second clock signal are different. The filter is configured to filter the detection result to generate a filtered detection result. The oscillator is configured to control frequencies of the first clock signal and the second clock signal, or control a frequency of the phase detector sampling clock signal according to the filtered detection result.

### Brief Description of the Drawings

FIG. 1 is a diagram illustrating a receiver according to one embodiment of the present invention.
FIG. 2 is a diagram illustrating a phase interpolator according to one embodiment of the present invention.
FIG. 3 is a diagram illustrating the shaper reshaping the square-wave clock signals CK2 into the shaped clock signals with triangular wave.
FIG. 4 is a diagram illustrating the phase of the clock signal locking the frequency/phase of input signal.
FIG. 5 is a diagram illustrating a phase interpolator according to one embodiment of the present invention.
FIG. 6 is a diagram illustrating a phase interpolator according to one embodiment of the present invention.
FIG. 7 is a diagram illustrating a phase interpolator according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

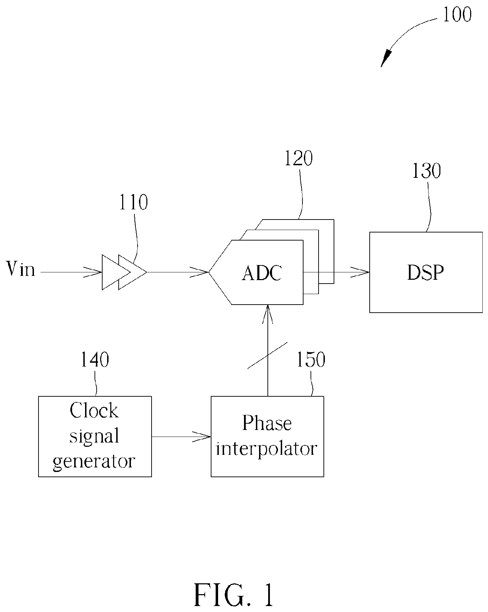

FIG. 1 is a diagram illustrating a receiver 100 according to one embodiment of the present invention. As shown in FIG. 1, the receiver 100 comprises a buffer 110, multiple analog-to-digital converters (ADCs) 120, a digital signal processor (DSP), a clock signal generator 140 and a phase interpolator 150. The ADCs 120, part of the DSP 130 and the phase interpolator 150 can be regarded as a CDR which is used to extract timing information from an input signal Vin, and to generate clock signals synchronized with input signal Vin, and simultaneously recover the data.

In the main operation of the receiver 100, the input signal Vin is inputted into the ADCs 120 via the buffer 110, and the ADCs uses the clock signals outputted by the phase interpolator 150 to sample the input signal Vin to generate sampled data. Then, the DSP 130 receives theses sampled data to generate a control signal to control the phase interpolator to adjust the phases of the clock signals, so that the ADCs 120 can use the clock signals with suitable phases to sample the input signal Vin.

Because the main operations of the receiver 100 with PI-based CDR are known by a person skilled in the art, and the present invention focuses on the circuit design of the phase interpolator, the content of the following embodiments describes only the phase interpolator.

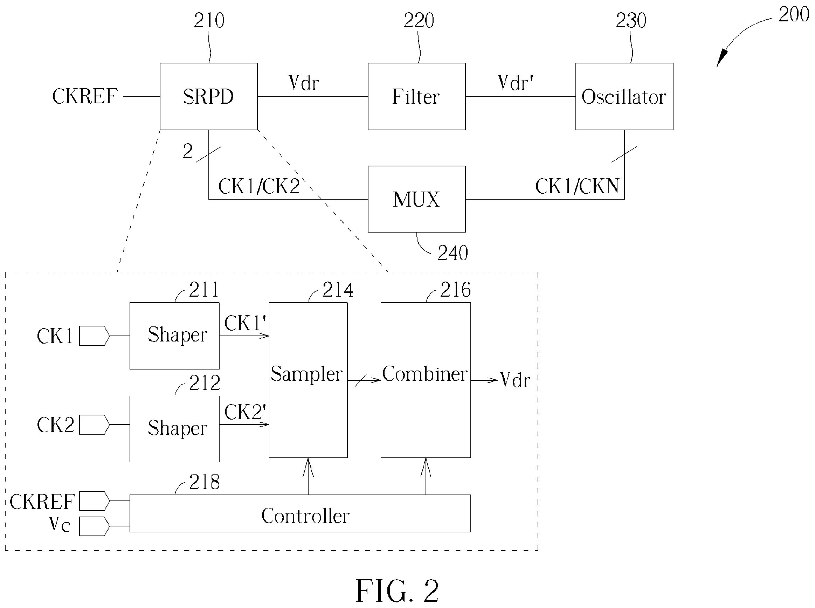

FIG. 2 is a diagram illustrating a phase interpolator 200 according to one embodiment of the present invention, wherein the phase interpolator can also be named as a sampling phase interpolator. As shown in FIG. 2, the phase interpolator 200 comprises a phase detector (in this embodiment, a sampling rotational phase detector (SRPD) 210 serves as the phase detector), a filter 220, an oscillator 230 and a multiplexer 240. The SRPD 210 comprises shapers 211, 212, a sampler 214, a combiner 216 and a controller 218, wherein the above-mentioned components within the phase interpolator 200 are implemented by hardware circuits.

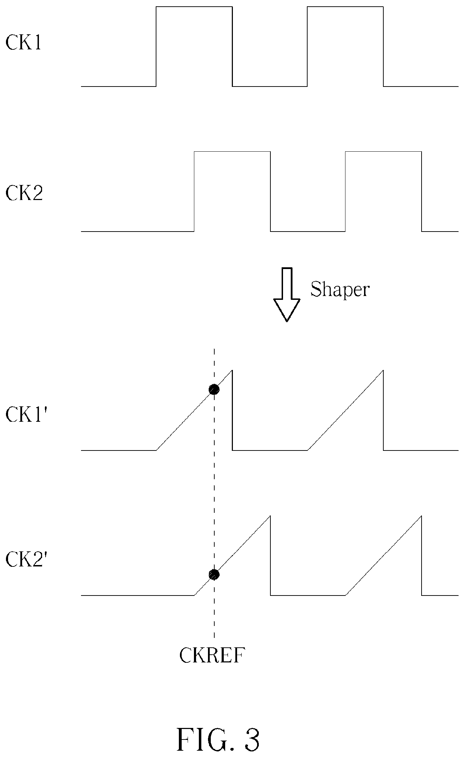

In the operation of the phase interpolator 200, the SRPD 210 receives a reference clock signal CKREF and two clock signals CK1 and CK2, and uses the reference clock signal CKREF to sample the clock signals CK1 and CK2 to generate a detection result Vdr, wherein the clock signals CK1 and CK2 have same frequency but different phases; for example, the clock signals CK1 and CK2 have a 90-degree phase difference. Specifically, the clock signals CK1 and CK2 pass through the shapers 211 and 212 to generate shaped clock signals CK1' and CK2', respectively, wherein the shapers 211 and 212 may reshape the square-wave clock signals CK1 and CK2 into the shaped clock signals CK1' and CK2' with triangular wave, as shown in FIG. 3. It is noted that the triangular wave shown in FIG. 3 is for illustrative, not a limitation of the present invention. In other embodiments, the shaped clock signals CK1' and CK2' may have a parabolic, sinusoidal, or other suitable waveform. Then, the sampler 214 uses the reference clock signal CKREF to sample the shaped clock signal CK1' to generate a first sampling result, and uses the reference clock signal CKREF to sample the shaped clock signal CK2' to generate a second sampling result. Referring to FIG. 3, since the phases of shaped clock signals CK1' and CK2' are different, the first sampling result and the second sampling result have different values. Then, the combiner 216 combines the first sampling result and the second sampling result to generate the detection result Vdr of the SRPD 210. In one embodiment, the DSP 130 generates a control signal Vc to the controller 218 to determine weights of the first sampling result and the second sampling result, and the combiner 216 can perform a weighted summation on the first sampling result and the second sampling result to generate the detection result Vdr, wherein the control signal Vc can be generated according to the sampled data generated by the ADCs 120 or other mechanisms that make the rising or falling edge of the clock signal generated by the phase interpolator 200 to quickly approach the eye diagram center of the input signal Vin.

Then, the filter 220 filters the detection result Vdr to generate a filtered detection result Vdr'. In one embodiment, the filter 220 may be a low-pass filter. In another embodiment, the filter 220 may compare the detection result Vdr with a reference signal to generate filtered detection result Vdr'.

The detection result Vdr and the filtered detection result Vdr' can be voltage signals or current signals.

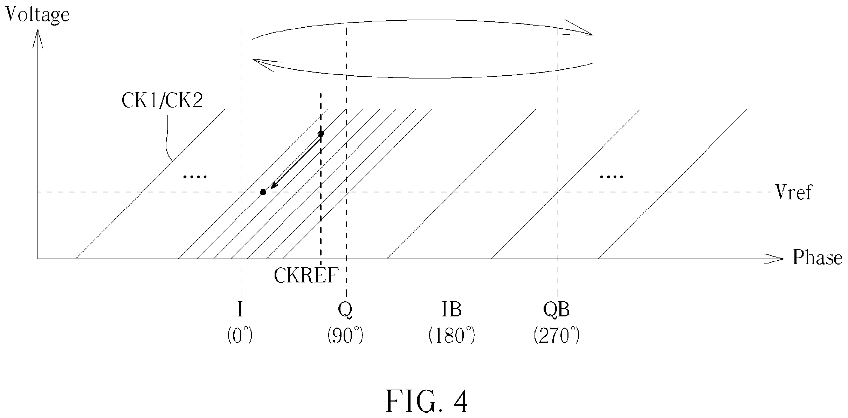

The oscillator 230 can be a voltage-controlled oscillator or a current-controlled oscillator, which determines the frequencies of the clock signals CK1 - CKN according to the filtered detection result Vdr'. In one embodiment, referring to FIG. 4, the clock signals CK1 - CKN are four clock signals with different phases, for example, the phases of the clock signals CK1 - CKN correspond to 0 degrees, 90 degrees, 180 degrees, and 270 degrees, respectively. In addition, the clock signals CK1 - CKN are outputted to the ADCs 120 for sampling the input signal Vin.

Then, the multiplexer 240 selects two of the clock signals CK1 - CKN according to the control of the DSP 130. In this embodiment, the clock signals CK1 and CK2 serve as the output of the multiplexer 240.

In one embodiment, the filter 220 may compare the detection result Vdr with a reference signal Vref to generate filtered detection result Vdr', and the oscillator 230 increases the frequencies of clock signals CK1 - CKN when the detection result Vdr is greater than the reference signal Vref, and decreases the frequencies of clock signals CK1 - CKN when the detection result Vdr is lower than the reference signal Vref. Referring to FIG. 4 together, the entire operation can be regarded as the phases of the clock signals CK1/CK2 are rotated to lock the frequency/phase of the input signal Vin; and by using the phase interpolator 200, the phases of the clock signal CK1/CK2 can be adjusted quickly so that the detection result Vdr can close to the reference signal Vref.

In addition, by using a single oscillator (i.e., oscillator 230) to generate multiple clock signals CK1 - CKN with different phases, the oscillator 230 can avoid issues caused by inconsistent circuit susceptibility to PVT (Process, Voltage, Temperature) variations that arise from semiconductor process deviations.

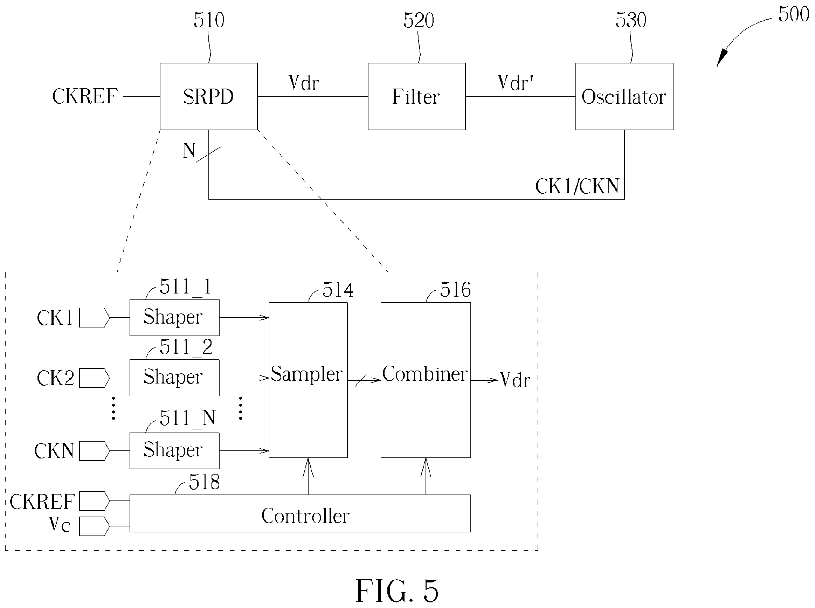

FIG. 5 is a diagram illustrating a phase interpolator 500 according to one embodiment of the present invention, wherein the phase interpolator can also be named as a sampling phase interpolator, and the phase interpolator 500 can be used to implement the phase interpolator 150 in FIG. 1. As shown in FIG. 5, the phase interpolator 500 comprises a phase detector (in this embodiment, a sampling rotational phase detector (SRPD) 510 serves as the phase detector), a filter 520 and an oscillator 530. The SRPD 510 comprises shapers 511_1 - 511_N, a sampler 514, a combiner 516 and a controller 518, wherein the above-mentioned components within the phase interpolator 500 are implemented by hardware circuits.

In the operation of the phase interpolator 500, the SRPD 510 receives a reference clock signal CKREF and multiple clock signals CK1 - CKN, and uses the reference clock signal CKREF to sample any plurality of the clock signals CK1 - CKN to generate a detection result Vdr, wherein the clock signals CK1 - CKN have different phases. Specifically, the clock signals CK1 - CKN pass through the shapers 511_1 - 511_N to generate shaped clock signals, respectively, wherein the shapers 511_1 - 511_N may reshape the square-wave clock signals CK1 - CKN into the shaped clock signals with triangular wave, as shown in FIG. 3. It is noted that the triangular wave shown in FIG. 3 is for illustrative, not a limitation of the present invention. Then, the sampler 514 uses the reference clock signal CKREF to sample the plurality of clock signals CK1 - CKN to generate a plurality of sampling results, wherein the selection of the clock signals CK1 - CKN can be determined by the DSP 130, and the selected plurality of clock signals have difference phases, for example, 90-degree phase difference. Then, the combiner 516 combines the plurality of sampling results to generate the detection result Vdr of the SRPD 510. In one embodiment, the DSP 130 generates a control signal Vc to the controller 518 to determine weights of the plurality of sampling result individually, and the combiner 516 can perform a weighted summation on the plurality of sampling results to generate the detection result Vdr, wherein the control signal Vc can be generated according to the sampled data generated by the ADCs 120 or other mechanisms that make the rising or falling edge of the clock signal generated by the phase interpolator 500 to quickly approach the eye diagram center of the input signal Vin.

Then, the filter 520 filters the detection result Vdr to generate a filtered detection result Vdr'. In one embodiment, the filter 520 may be a low-pass filter. In another embodiment, the filter 520 may compare the detection result Vdr with a reference signal to generate filtered detection result Vdr'.

The oscillator 530 can be a voltage-controlled oscillator or a current-controlled oscillator, which determines the frequencies of the clock signals CK1 - CKN according to the filtered detection result Vdr'. In one embodiment, referring to FIG. 4, the clock signals CK1 - CKN are four clock signals with different phases, for example, the phases of the clock signals CK1 - CKN correspond to 0 degrees, 90 degrees, 180 degrees, and 270 degrees, respectively. In addition, the clock signals CK1 - CKN are outputted to the ADCs 120 for sampling the input signal Vin.

Similar to the embodiment shown in FIG. 2, by using the phase interpolator 500, the phases of the clock signals CK1 - CKN can be adjusted quickly, and variations among multiple components due to PVT variations can be mitigated.

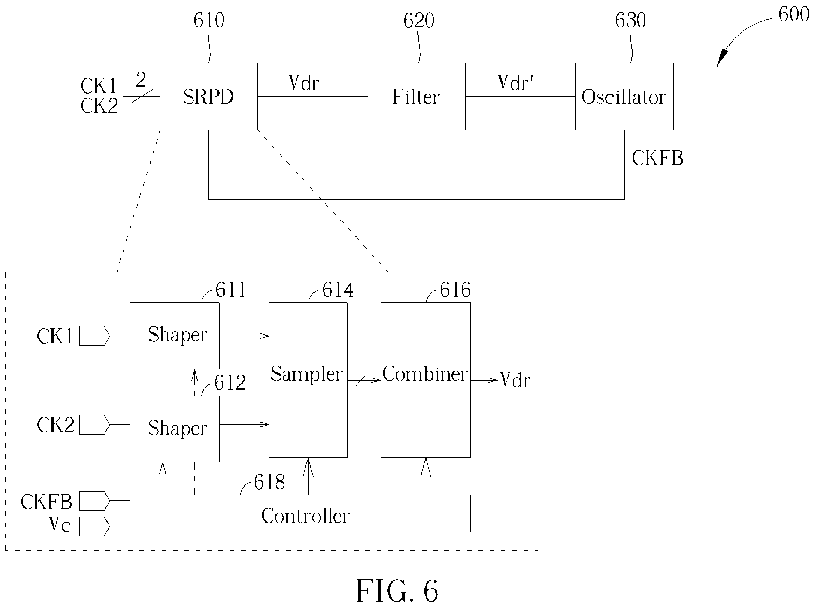

FIG. 6 is a diagram illustrating a phase interpolator 600 according to one embodiment of the present invention, wherein the phase interpolator can also be named as a sampling phase interpolator. As shown in FIG. 6, the phase interpolator 600 comprises a phase detector (in this embodiment, a sampling rotational phase detector (SRPD) 610 serves as the phase detector), a filter 620 and an oscillator 630. The SRPD 610 comprises shapers 611, 612, a sampler 614, a combiner 616 and a controller 618, wherein the above-mentioned components within the phase interpolator 600 are implemented by hardware circuits.

In the operation of the phase interpolator 600, the SRPD 610 receives a feedback clock signal CKFB generated from oscillator and two clock signals CK1 and CK2 from external multiphase reference clock, and uses the feedback clock signal CKFB to sample the clock signals CK1 and CK2 to generate a detection result Vdr, wherein the clock signals CK1 and CK2 have different phases; for example, the clock signals CK1 and CK2 have a 90-degree phase difference. Specifically, the clock signals CK1 and CK2 pass through the shapers 611 and 612 to generate shaped clock signals CK1' and CK2', respectively, wherein the shapers 211 and 212 may reshape the square-wave clock signals CK1 and CK2 into the shaped clock signals CK1' and CK2' with triangular wave, as shown in FIG. 3. It is noted that the triangular wave shown in FIG. 3 is for illustrative, not a limitation of the present invention. Then, the sampler 614 uses the feedback clock signal CKFB to sample the shaped clock signal CK1' to generate a first sampling result, and uses the feedback clock signal CKFB to sample the shaped clock signal CK2' to generate a second sampling result. Then, the combiner 616 combines the first sampling result and the second sampling result to generate the detection result Vdr of the SRPD 610. In one embodiment, the DSP 130 generates a control signal Vc to the controller 618 to determine weights of the first sampling result and the second sampling result, and the combiner 616 can perform a weighted summation on the first sampling result and the second sampling result to generate the detection result Vdr, wherein the control signal Vc can be generated according to the sampled data generated by the ADCs 120 or other mechanisms that make the rising or falling edge of the clock signal generated by the phase interpolator 600 to quickly approach the eye diagram center of the input signal Vin.

Then, the filter 620 filters the detection result Vdr to generate a filtered detection result Vdr'. In one embodiment, the filter 620 may be a low-pass filter. In another embodiment, the filter 620 may compare the detection result Vdr with a reference signal to generate filtered detection result Vdr'.

The oscillator 630 can be a voltage-controlled oscillator or a current-controlled oscillator, which determines the frequency of the feedback clock signals CKFB according to the filtered detection result Vdr'.

Similar to the embodiment shown in FIG. 2, by using the phase interpolator 600, the phases of the clock signals CK1 - CKN can be adjusted quickly, and variations among multiple components due to PVT variations can be mitigated.

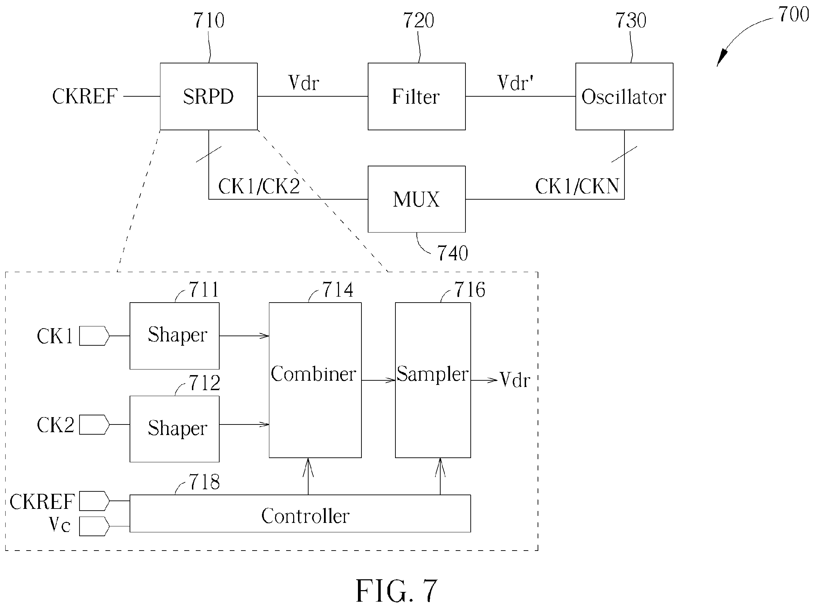

FIG. 7 is a diagram illustrating a phase interpolator 700 according to one embodiment of the present invention, wherein the phase interpolator can also be named as a sampling phase interpolator. As shown in FIG. 7, the phase interpolator 700 comprises a phase detector (in this embodiment, a sampling rotational phase detector (SRPD) 710 serves as the phase detector), a filter 720, an oscillator 730 and a multiplexer 740. The SRPD 710 comprises shapers 711, 712, a combiner 714, a sampler 716 and a controller 718, wherein the above-mentioned components within the phase interpolator 700 are implemented by hardware circuits.

In the operation of the phase interpolator 700, the SRPD 710 receives a reference clock signal CKREF and two clock signals CK1 and CK2, and uses the reference clock signal CKREF to sample the clock signals CK1 and CK2 to generate a detection result Vdr, wherein the clock signals CK1 and CK2 have different phases; for example, the clock signals CK1 and CK2 have a 90-degree phase difference. Specifically, the clock signals CK1 and CK2 pass through the shapers 711 and 712 to generate shaped clock signals CK1' and CK2', respectively, wherein the shapers 711 and 712 may reshape the square-wave clock signals CK1 and CK2 into the shaped clock signals CK1' and CK2' with triangular wave, as shown in FIG. 3. It is noted that the triangular wave shown in FIG. 3 is for illustrative, not a limitation of the present invention. Then, the combiner 714 combines the shaped clock signals CK1' and CK2' to generate a combined clock signal. In one embodiment, the DSP 130 generates a control signal Vc to the controller 618 to determine weights of the shaped clock signals CK1' and CK2', and the combiner 714 can perform a weighted summation on the shaped clock signals CK1' and CK2' to generate the combined clock signal, wherein the control signal Vc can be generated according to the sampled data generated by the ADCs 120 or other mechanisms that make the rising or falling edge of the clock signal generated by the phase interpolator 700 to quickly approach the eye diagram center of the input signal Vin. Then, the sampler 716 uses the reference clock signal CKREF to sample the combined clock signal to generate the detection result Vdr.

Then, the filter 720 filters the detection result Vdr to generate a filtered detection result Vdr'. In one embodiment, the filter 720 may be a low-pass filter. In another embodiment, the filter 720 may compare the detection result Vdr with a reference signal to generate filtered detection result Vdr'.

The oscillator 730 can be a voltage-controlled oscillator or a current-controlled oscillator, which determines the frequencies of the clock signals CK1 - CKN according to the filtered detection result Vdr'.

Then, the multiplexer 740 selects two of the clock signals CK1 - CKN according to the control of the DSP 130. In this embodiment, the clock signals CK1 and CK2 serve as the output of the multiplexer 240.

Similar to the embodiment shown in FIG. 2, by using the phase interpolator 700, the phases of the clock signals CK1 - CKN can be adjusted quickly, and variations among multiple components due to PVT variations can be mitigated.

## Claims

1. A phase interpolator (200, 500, 600, 700), comprising:
a phase detector (210, 510, 610, 710), configured to receive a first clock signal and a second clock signal, and sample the first clock signal and the second clock signal to generate a detection result, wherein phases of the first clock signal and the second clock signal are different;
a filter (220, 520, 620, 720), configured to filter the detection result to generate a filtered detection result; and
an oscillator (230, 530, 630, 730), configured to control frequencies of the first clock signal and the second clock signal, or control a frequency of a sampling clock signal of the phase interpolator according to the filtered detection result.

2. The phase interpolator (200) of claim 1, wherein the phase detector (210) comprises:
a sampler (214), configured to use a reference clock signal to sample the first clock signal and the second clock signal to generate a first sampling result and a second sampling result, respectively; and
a combiner (216), configured to combine the first sampling result and the second sampling result to generate the detection result.

3. The phase interpolator (200) of claim 2, wherein the phase detector (210) further comprises:
a first shaper (211), configured to reshape the first clock signal to generate a shaped first clock signal; and
a second shaper (212), configured to reshape the second clock signal to generate a shaped second clock signal;
wherein the sampler (214) uses the reference clock signal to sample the shaped first clock signal and the shaped second clock signal to generate the first sampling result and the second sampling result, respectively.

4. The phase interpolator (200) of claim 2 or 3, wherein the combiner (216) performs a weighted summation on the first sampling result and the second sampling result to generate the detection result.

5. The phase interpolator of claim 2, 3 or 4, wherein the oscillator (230) controls frequencies of multiple clock signals according to the filtered detection result, and the phase interpolator (200) further comprises:
a multiplexer (240), configured to select the first clock signal and the second clock signal from the multiple clock signals, and output the first clock signal and the second clock signal to the phase detector.

6. The phase interpolator (500) of claim 1, wherein the oscillator (530) controls frequencies of multiple clock signals according to the filtered detection result, and the phase detector (510) comprises:
multiple shapers (511_1 - 511_N), configured to reshape the multiple clock signals to generate multiple shaped clock signals, respectively
a sampler (514), configured to select a portion of the shaped clock signals, and to sample the selected portion of the shaped clock signals using a reference clock signal to generate multiple sampling results; and
a combiner (516), configured to combine the multiple sampling results corresponding to the selected portion of the shaped clock signals to generate the detection result.

7. The phase interpolator (500) of claim 6, wherein the combiner (516) performs a weighted summation on the first sampling result and the second sampling result to generate the detection result.

8. The phase interpolator (600) of claim 1, wherein the oscillator (630) controls the frequency of the sampling clock signal according to the filtered detection result, the sampling clock signal is a feedback clock signal, and the phase detector (610) comprises:
a sampler (614), configured to use the feedback clock signal to sample the first clock signal and the second clock signal from a reference clock to generate a first sampling result and a second sampling result, respectively; and
a combiner (616), configured to combine the first sampling result and the second sampling result to generate the detection result.

9. The phase interpolator (600) of claim 8, wherein the phase detector (610) further comprises:
a first shaper (611), configured to reshape the first clock signal to generate a shaped first clock signal; and
a second shaper (612), configured to reshape the second clock signal to generate a shaped second clock signal;
wherein the sampler (614) uses the reference clock signal to sample the shaped first clock signal and the shaped second clock signal to generate the first sampling result and the second sampling result, respectively.

10. The phase interpolator (600) of claim 8, wherein the combiner (616) performs a weighted summation on the first sampling result and the second sampling result to generate the detection result.

11. The phase interpolator (700) of claim 1, wherein the phase detector (710) comprises:
a combiner (714), configured to combine the first clock signal and the second clock signal to generate a combined clock signal; and
a sampler (716), configured to use a reference clock signal to sample the combined clock signal to generate the detection result.

12. The phase interpolator (700) of claim 11, wherein the phase detector (710) further comprises:
a first shaper (711), configured to reshape the first clock signal to generate a shaped first clock signal; and
a second shaper (712), configured to reshape the second clock signal to generate a shaped second clock signal;
wherein the combiner (714) combines the shaped first clock signal and the shaped second clock signal to generate the combined clock signal.

13. The phase interpolator (700) of claim 11, wherein the combiner (714) performs a weighted summation on the first clock signal and the second clock signal to generate the combined clock signal.
